# EUROPÄISCHE PATENTANMELDUNG

(11) **EP 2 658 034 A1**
(43) Veröffentlichungstag der Anmeldung: **30.10.2013**
(21) Anmeldenummer: 12166004.7
(22) Anmeldetag: 27.04.2012
(51) Int. Cl.: H01R 4/62, H01M 10/42, G01R 31/36, H01M 10/48

(54) **Spannungsabgriffelement, Zellüberwachungseinheit, Batterieeinheit und Herstellungsverfahren dazu**

(71) Anmelder: Magna E-Car Systems GmbH & Co OG, 8041 Graz (AT)
(72) Erfinder: Erhart, Michael, 8075 Hart bei Graz (AT); Geidl, Uwe, 8101 Gratkorn (AT); Hafellner, Martin, 8644 Mürzhofen (AT); Korherr, Thomas, 8230 Hartberg (AT)
(74) Vertreter: Rausch, Gabriele

(57) **Zusammenfassung**

Ein Spannungsabgriffelement (1) zum Abgriff der Spannung einer Batteriezelle (2) einer Batterieeinheit (3) durch eine Elektronikeinheit (4), wobei das Spannungsabgriffelement (1) als Bügel ausgeführt ist, wobei der Bügel aus einem ersten Metall besteht, wobei das erste Ende des Bügels einen ersten Kontaktbereich (5) zur Verbindung mit der Elektronikeinheit (4) aufweist und im ersten Kontaktbereich (5) der Bügel mit einem Zwischenstück (6) aus einem vom ersten Metall verschiedenen, in SMD-Technologie lötbaren zweiten Metall dauerhaft verbunden ist, wobei das Zwischenstück (6) dazu ausgebildet ist, durch eine Lötverbindung in SMD-Technologie mit der Elektronikeinheit (4) verbunden zu werden, und wobei das zweite Ende des Bügels einen zweiten Kontaktbereich (7) zur Verbindung mit der Batteriezelle (2) aufweist; eine Zellüberwachungseinheit mit solchen Spannungsabgriffelementen, eine Batterieeinheit mit einer solchen Zellüberwachungseinheit und Verfahren zur Herstellung der Zellüberwachungseinheit und der Batterieeinheit.

## Beschreibung

### Gebiet der Erfindung

Die vorliegende Erfindung betrifft ein Spannungsabgriffelement zum Abgriff der Spannung einer Batteriezelle einer Batterieeinheit durch eine Elektronikeinheit. Die Erfindung betrifft weiters eine Zellüberwachungseinheit, umfassend eine Elektronikeinheit und mehrere Spannungsabgriffelemente und ein Verfahren zur Herstellung einer solchen Zellüberwachungseinheit. Schließlich betrifft die Erfindung auch eine Batterieeinheit mit einer Zellüberwachungseinheit und ein Verfahren zur Herstellung einer Batterieeinheit mit einer Zellüberwachungseinheit.

### Stand der Technik

Derartige Vorrichtungen werden bekanntermaßen benutzt um die Spannungen der einzelnen Zellen einer Batterieeinheit durch eine Elektronikeinheit, insbesondere durch eine Zellüberwachungsschaltung (cell supervisory circuit, CSC) zu überwachen. Hierdurch kann beispielsweise der Ladezustand der Batteriezellen festgestellt werden und ein Ladungsausgleich der Zellen vorgenommen werden.

Für den Spannungsabgriff selbst, also die Verbindung zwischen den Zellen bzw. den Zellpolen bzw. Zellverbindern einerseits und der Elektronikeinheit andererseits werden üblicherweise Kupferkabel eingesetzt. Für die Herstellung der Kontakte zwischen den Kupferkabeln und der Batteriezelle sind zwar Methoden, wie beispielsweise Schrauben oder Crimpen bekannt, die jedoch eine aufwändige Fertigung bedingen. Da zum Erreichen höherer Spannungen üblicherweise viele Zellen in einer Batterieeinheit eingesetzt werden müssen, ergibt sich weiters das Problem eine Vielzahl von Kupferkabeln richtig zwischen den Zellen und den zugehörenden Anschlusspunkten der Elektronikeinheit zu verbinden. Entsprechend stellt sich die Herstellung von Zellüberwachungseinheiten und von Batterieeinheiten mit solchen Zellüberwachungseinheiten durch Kabelverbindungen als aufwändig und fehleranfällig dar.

### Zusammenfassung der Erfindung

Es ist eine Aufgabe der Erfindung, Spannungsabgriffelemente, Zellüberwachungseinheiten mit derartigen Spannungsabgriffelementen und Batterieeinheiten mit derartigen Zellüberwachungseinheiten in dieser Hinsicht zu verbessern und diese insbesondere so auszubilden, dass eine einfache, kostengünstige und wenig fehleranfällige Herstellung der Zellüberwachungseinheiten und der Batterieeinheiten mit solchen Zellüberwachungseinheiten möglich ist. Weiters ist eine Aufgabe der Erfindung die entsprechenden einfachen, kostengünstigen und wenig fehleranfälligen Verfahren zur Herstellung der Zellüberwachungseinheiten und der Batterieeinheiten mit solchen Zellüberwachungseinheiten anzugeben.

Die Lösung der Aufgabe erfolgt durch ein Spannungsabgriffelement zum Abgriff der Spannung einer Batteriezelle einer Batterieeinheit durch eine Elektronikeinheit, wobei das Spannungsabgriffelement als Bügel ausgeführt ist, wobei der Bügel aus einem ersten Metall besteht, wobei das erste Ende des Bügels einen ersten Kontaktbereich zur Verbindung mit der Elektronikeinheit aufweist und im ersten Kontaktbereich der Bügel mit einem Zwischenstück aus einem vom ersten Metall verschiedenen, in SMD-Technologie lötbaren zweiten Metall dauerhaft verbunden ist, wobei das Zwischenstück dazu ausgebildet ist, durch eine Lötverbindung in SMD-Technologie mit der Elektronikeinheit verbunden zu werden, und wobei das zweite Ende des Bügels einen zweiten Kontaktbereich zur Verbindung mit der Batteriezelle aufweist.

Die Lösung erfolgt auch durch eine Zellüberwachungseinheit, umfassend eine Elektronikeinheit und mehrere erfindungsgemäße Spannungsabgriffelemente, wobei die Spannungsabgriffelemente über deren Zwischenstücke in SMD-Technologie mit der Elektronikeinheit lötverbunden sind.

Weiters erfolgt die Lösung durch ein Verfahren zur Herstellung einer erfindungsgemäßen Zellüberwachungseinheit, wobei die Spannungsabgriffelemente an deren Zwischenstücken in SMD-Technologie auf die Elektronikeinheit gelötet werden.

Die Lösung erfolgt weiters durch eine Batterieeinheit mit einer erfindungsgemäßen Zellüberwachungseinheit.

Schließlich erfolgt die Lösung auch durch ein Verfahren zur Herstellung einer Batterieeinheit mit einer erfindungsgemäßen Zellüberwachungseinheit aufweisend die Schritte,
- Einlegen der Zellüberwachungseinheit mit vorbestückten Spannungsabgriffelementen in ein Gehäuse,
- Einlegen von Zellverbindern in das Gehäuse, so dass die Zellverbinder jeweils mit den zweiten Kontaktbereichen der Spannungsabgriffelemente der Zellüberwachungseinheit in Kontakt stehen,
- Auflegen des Gehäuses mit der Zellüberwachungseinheit und den Zellverbindern auf die Batterieeinheit, so dass die Zellverbinder mit Zellpolen der Batterieeinheit in Kontakt stehen,
- Verschweißen der Zellverbinder mit den Zellpolen und der zweiten Kontaktbereiche der Spannungsabgriffelemente mit den Zellverbindern.

Erfindungsgemäß ist zur Herstellung der Verbindung zwischen einer Elektronikeinheit und Batteriezellen ein Bügel vorgesehen. Ein Bügel weist dabei eine gegenüber Kabeln erhöhte Steifigkeit auf, so dass die Bügel ihre Lage insbesondere auch nach Aufbringung auf die Elektronikeinheit beibehalten, was die Zuordnung zu den passenden Zellen bzw. Zellverbindern wesentlich erleichtert.

Der Bügel ist aus einem ersten Metall hergestellt um eine einfache Verbindbarkeit mit den Zellen, insbesondere mit Zellverbindern, die bevorzugt aus dem selben Metall bestehen, insbesondere durch Schweißen sicherzustellen. Der Bügel muss elektrisch leitfähig sein.

An einem Ende ist der Bügel mit einem Zwischenstück aus einem vom ersten Metall verschiedenen zweiten Metall dauerhaft verbunden, welches zweite Metall in SMD-Technologie lötbar sein muss. Durch dieses Zwischenstück ist gesichert, dass das erfindungsgemäße Spannungsabgriffelement in SMD-Technologie auf der Elektronikeinheit vorbestückt werden kann. Das Zwischenstück ist dazu geeignet ausgeführt, also beispielsweise im Wesentlichen flach und kleinflächig dimensioniert.

Weiterbildungen der Erfindung sind in den abhängigen Ansprüchen, der Beschreibung sowie den beigefügten Zeichnungen angegeben.

Bevorzugt besteht der Bügel aus Aluminium. Aluminium weist ein geringes Gewicht und hohe elektrische Leitfähigkeit auf. Zudem sind vorteilhaft auch die Zellpole und/oder Zellverbinder aus Aluminium hergestellt und daher leicht mit einem Aluminium-Bügel verschweißbar. Alternativ kann der Bügel auch beispielsweise aus Stahl hergestellt sein.

Bevorzugt besteht das Zwischenstück aus Kupfer, so dass es gut mit üblicherweise ebenfalls aus Kupfer ausgeführten Leitungen bzw. Kontaktbereichen der Elektronikeinheit verlötbar ist. Alternativ kann das Zwischenstück auch aus anderen lötbaren Materialien bestehen, wie beispielsweise aus Nickel, Zink, Zinn sowie deren Legierungen, wie beispielsweise Messing oder Bronze.

Das in SMD-Technologie lötbare Metall des Zwischenstücks ist vorzugsweise zur weiteren Verbesserung der Lötbarkeit verzinnt.

In einer bevorzugten Ausführungsform ist das Zwischenstück mit dem Bügel durch Plattierung, insbesondere durch Walzplattierung, verbunden. Dadurch wird eine zuverlässige und dauerhafte Befestigung des Zwischenstückes auf dem Bügel sichergestellt.

Bevorzugt weist der Mittelteil des Bügels gegenüber den Kontaktbereichen einen verringerten Querschnitt auf, insbesondere eine verringerte Breite des Bügels. Hierdurch ist eine gute Leitfähigkeit und verringerter Materialbedarf gegeben.

Besonders bevorzugt weist der Mittelteil des Bügels zumindest eine Krümmung oder einen Versatz oder eine Kröpfung auf, insbesondere kann der Mittelteil des Bügels U-förmig oder S-förmig ausgeführt sein. Durch diese Ausformungen des Bügels, die dessen Elastizität erhöhen, ist ein Toleranzausgleich zwischen der Elektronikeinheit und den Zellen gegeben. Weiters wird dadurch die Vibrationsbelastung für Schweiß- oder Lötstellen zwischen dem Bügel und den Zellen bzw. dem Bügel und der Elektronikeinheit verringert.

Gemäß einer Ausführungsform der Erfindung weist der Mittelteil des Bügels einen Haltevorsatz auf. Dieser Vorsatz bietet eine gute Angriffsfläche für Werkzeuge während der Fertigung, insbesondere während der Fügung des Bügels an Zellverbinder und/oder die Elektronikeinheit.

Weiters kann der Mittelteil des Bügels bevorzugt eine vertikale Kröpfung als Positionierhilfe aufweisen. Vertikal ist dabei verstanden als normal zu den Kontaktflächen des Bügels. Während des Verlötens eines Spannungsabgriffelementes auf einer Elektronikeinheit wird das Spannungsabgriffelement vorteilhaft zur korrekten Positionierung auf eine vorgefertigte Aufnahmeplatte gelegt. Die Aufnahmeplatte weist entsprechende Einkerbungen zur Aufnahme der vertikalen Kröpfungen auf, so dass eine Ausrichtung während der Bestückung der Elektronikeinheit mit dem erfindungsgemäßen Spannungsabgriffelement sicher gestellt ist.

Gemäß einer bevorzugten Ausführungsform sind im zweiten Kontaktbereich zumindest eine, bevorzugt aber zwei oder mehr Schweißstellen vorgesehen. Der zweite Kontaktbereich muss dazu ausreichend Platz für die Schweißstellen zur Verfügung stellen. Eine Schweißstelle dient dabei der Verschweißung mit einer Zelle, insbesondere einem Zellverbinder oder einem Zellpol. Vorteilhaft finden im zweiten Kontaktbereich mehrere Schweißstellen Platz. Auf diese Wiese kann ein bereits mit einem Zellverbinder einer Batterie verschweißter Bügel beispielsweise durch Abfräsen bei Absaugung der Späne wieder entfernt werden und der selbe Bügel an einer weiteren Schweißstelle mit einem anderen Zellverbinder verschweißt werden. Dies ist insbesondere vorteilhaft, wenn die Spannungsabgriffelemente auf einer Elektronikeinheit vorbestückt sind, da hierdurch die gesamte Anordnung aus Elektronikeinheit und Spannungsabgriffelementen, beispielsweise wenn diese defekt ist, von einer Batterieeinheit entfernt werden kann, und durch eine andere derartige erfindungsgemäße Anordnung ersetzt werden kann.

Erfindungsgemäß umfasst eine Zellüberwachungseinheit eine Elektronikeinheit und mehrere Spannungsabgriffelemente, wobei die Spannungsabgriffelemente über deren Zwischenstücke in SMD-Technologie mit der Elektronikeinheit lötverbunden sind.

Die Elektronikeinheit ist bevorzugt eine Zellüberwachungsschaltung (cell supervisory circuit, CSC) und beherbergt daher üblicherweise einen Prozessor der zur Überwachung und meist auch zur Regelung der Zellspannungen eingerichtet ist.

In einer weiteren Ausführungsform ist die Elektronikeinheit eine Verbindungsplatine, die an eine Zellüberwachungsschaltung (cell supervisory circuit, CSC) anschließbar ist. Die Platine der Elektronikeinheit beherbergt in diesem Fall nur die erforderlichen Verbindungskanäle, die von den Kontakten mit den Spannungsabgriffelementen zu einem Anschluss für beispielsweise eine weitere Elektronikeinheit führen, die den Prozessor beherbergt.

Ein Verfahren zur Herstellung einer Batterieeinheit mit einer erfindungsgemäßen Zellüberwachungseinheit umfasst die Schritte:
- Einlegen der Zellüberwachungseinheit mit vorbestückten Spannungsabgriffelementen in ein Gehäuse,
- Einlegen von Zellverbindern in das Gehäuse, so dass die Zellverbinder jeweils mit den zweiten Kontaktbereichen der Spannungsabgriffelemente der Zellüberwachungseinheit in Kontakt stehen,
- Auflegen des Gehäuses mit der Zellüberwachungseinheit und den Zellverbindern auf die Batterieeinheit, so dass die Zellverbinder mit Zellpolen der Batterieeinheit in Kontakt stehen,
- Verschweißen der Zellverbinder mit den Zellpolen und der zweiten Kontaktbereiche der Spannungsabgriffelemente mit den Zellverbindern.

Erfindungsgemäß wird zuerst eine Zellüberwachungseinheit hergestellt, die aus der Elektronikeinheit und daran angelöteten Bügeln besteht. Diese Zellüberwachungseinheit kann beispielsweise vorgefertigt von einem Lieferanten bezogen werden und als fertige Einheit weiterverarbeitet werden.

Das Einlegen der Zellüberwachungseinheit und der Zellverbinder in das Gehäuse der Zellüberwachungseinheit kann beispielsweise als Einclipsen erfolgen, da die Bauteile bevorzugt von Ausformungen des Gehäuses und/oder von weiteren Bauteilen in ihrer Position im Gehäuse gehalten werden.

Nach dem Einlegen der Zellüberwachungseinheit und der Zellverbinder wird üblicherweise das Gehäuse um 180 Grad vertikal gedreht, so dass die Zellverbinder unten zu liegen kommen.

Die Zellüberwachungseinheit in ihrem Gehäuse wird sodann auf die Batterieeinheit, das heißt auf Batteriezellen mit ihren jeweiligen Zellpolen aufgesetzt.

Hierauf werden zunächst die Zellpole mit den Zellverbindern verschweißt und daraufhin die Zellverbinder mit den Spannungsabriffelementen, also den Kontaktbereichen der Bügel verschweißt. Hilfreich ist es dabei Öffnungen an der Oberseite des Gehäuses vorzusehen, durch welche das Verschweißen von jenseits des Gehäuses erfolgen kann.

### Kurzbeschreibung der Zeichnungen

Die Erfindung wird im Folgenden beispielhaft unter Bezugnahme auf die Zeichnungen beschrieben.
- Fig. 1: ist eine schematische Darstellung einer erfindungsgemäßen Batterieeinheit mit einer Zellüberwachungseinheit mit Spannungsabgriffelementen von der Seite und von oben.
- Fig. 2: ist eine Detaildarstellung eines Spannungsabgriffelementes zu 1 von oben.
- Fig. 3: ist eine Detaildarstellung einer weiteren Ausführungsform zu 1 von oben.
- Fig. 4: ist eine Detaildarstellung einer weiteren Ausführungsform zu 1 von oben.
- Fig. 5: ist eine Detaildarstellung einer weiteren Ausführungsform zu 1 von oben.
- Fig. 6: ist eine Detaildarstellung einer weiteren Ausführungsform zu 1 von oben.
- Fig. 7: ist eine Detaildarstellung einer weiteren Ausführungsform zu 1 von der Seite.
- Fig. 8: ist eine Detaildarstellung einer weiteren Ausführungsform zu 1 von der Seite.
- Fig. 9: ist eine Detaildarstellung einer weiteren Ausführungsform zu 1 von der Seite.
- Fig. 10: zeigt von a) bis d) den Ablauf eines erfindungsgemäßen Verfahrens zur Herstellung einer Batterieeinheit mit einer Zellüberwachungseinheit.

### Detaillierte Beschreibung der Erfindung

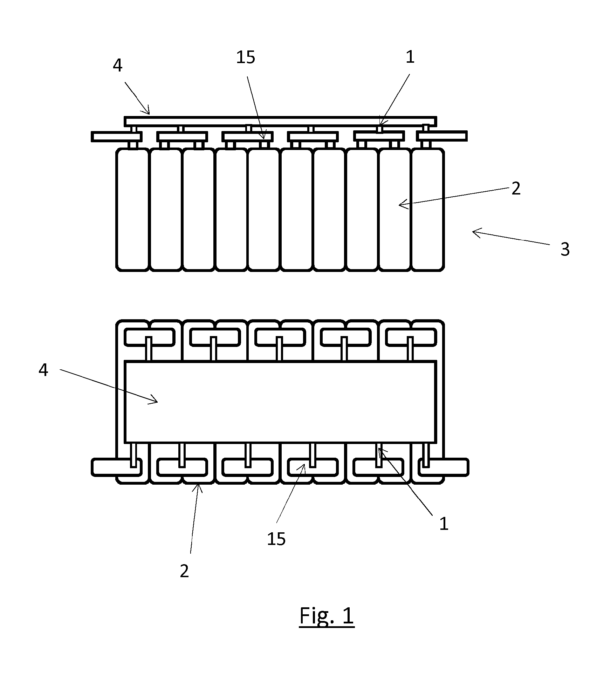

In Fig. 1 ist eine schematische Darstellung einer erfindungsgemäßen Batterieeinheit 3 mit einer Zellüberwachungseinheit mit Spannungsabgriffelementen 1 und Elektronikeinheit 4 von der Seite (obere Darstellung) und von oben (untere Darstellung) gezeigt. Die Batterieeinheit 3 umfasst eine Vielzahl von Batteriezellen 2. Am oberen Ende der Batteriezellen 2 befinden sich Zellpole, wobei jeweils zwei Zellpole durch Zellverbinder 15 verbunden sind. An diesen Zellverbindern 15 wird die durchschnittliche Spannung der betreffenden beiden Batteriezellen 2 abgenommen durch die Spannungsabgriffelemente 1.

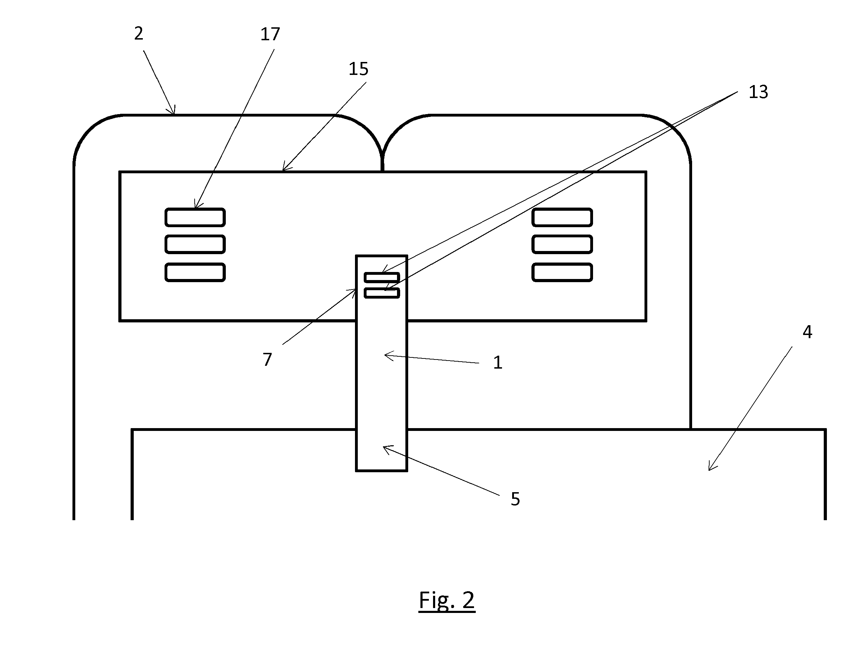

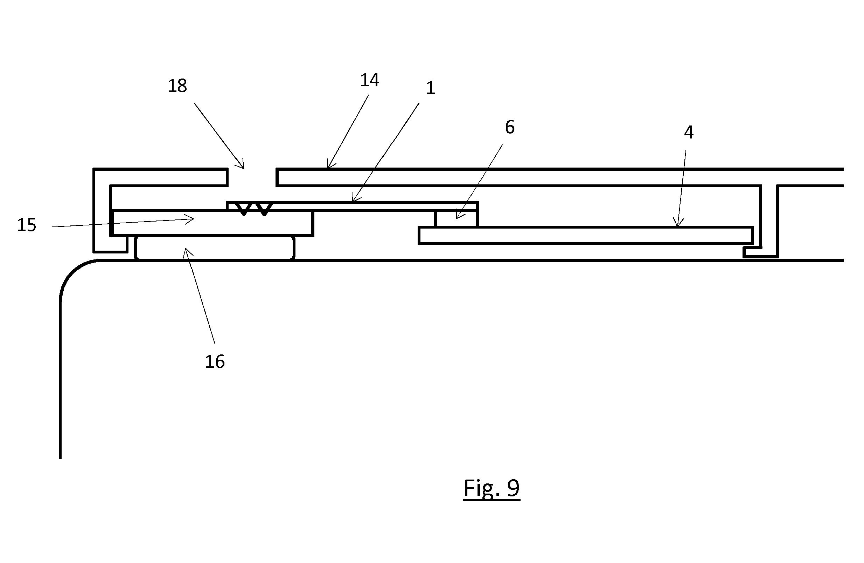

Wie in den Fig. 2 bis Fig. 9 in verschiedenen Ausführungsformen dargestellt, umfasst jedes Spannungsabgriffelement 1 einen ersten Kontaktbereich 5 zur Löt-Verbindung mit der Elektronikeinheit 4 und einen zweiten Kontaktbereich 7 zur Verbindung mit einem Zellverbinder 15. Stattdessen könnte der zweite Kontaktbereich auch direkt mit einem Zellpol 16 verbunden sein. Für die Verbindung des Spannungsabgriffelementes 1 mit einem Zellverbinder 15 sind Schweißstellen 13 vorgesehen. Die Zellverbinder 15 sind ihrerseits über Schweißstellen 17 mit den Zellpolen verschweißt.

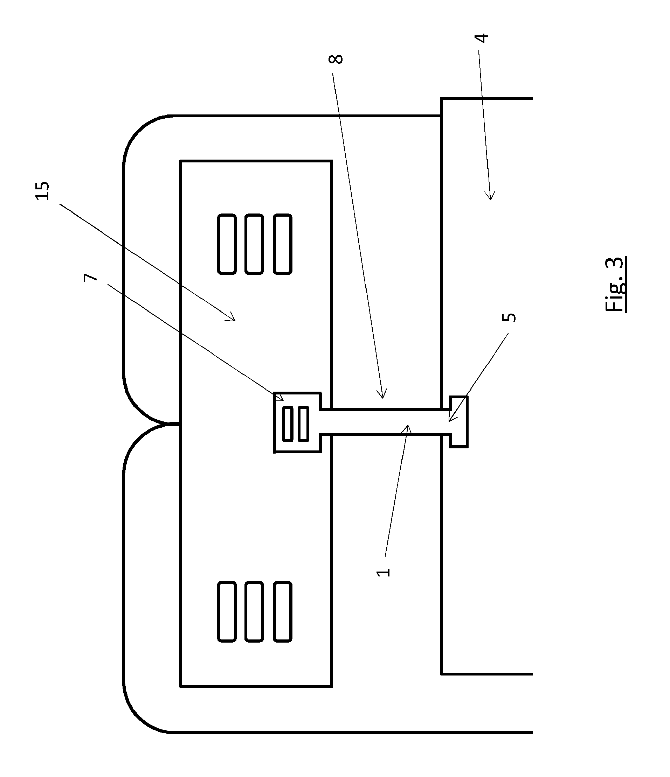

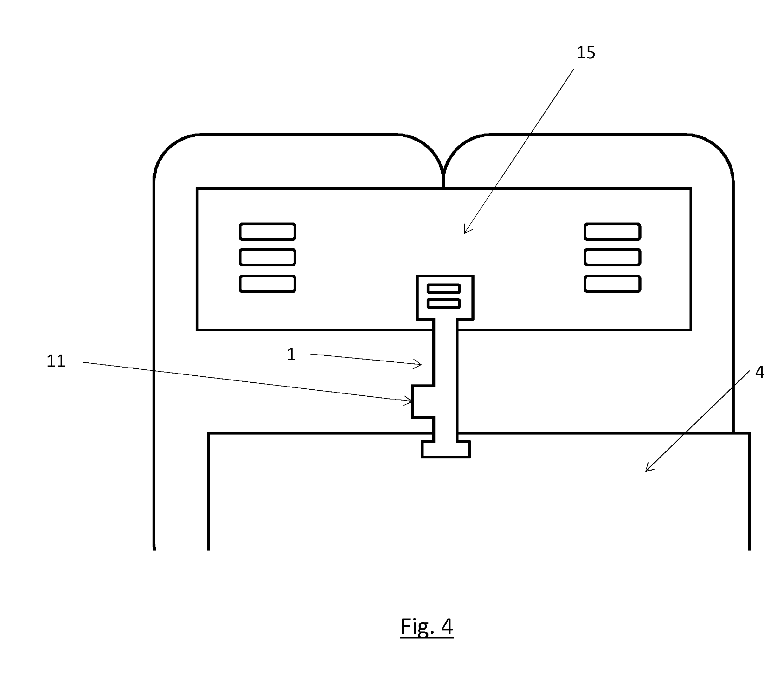

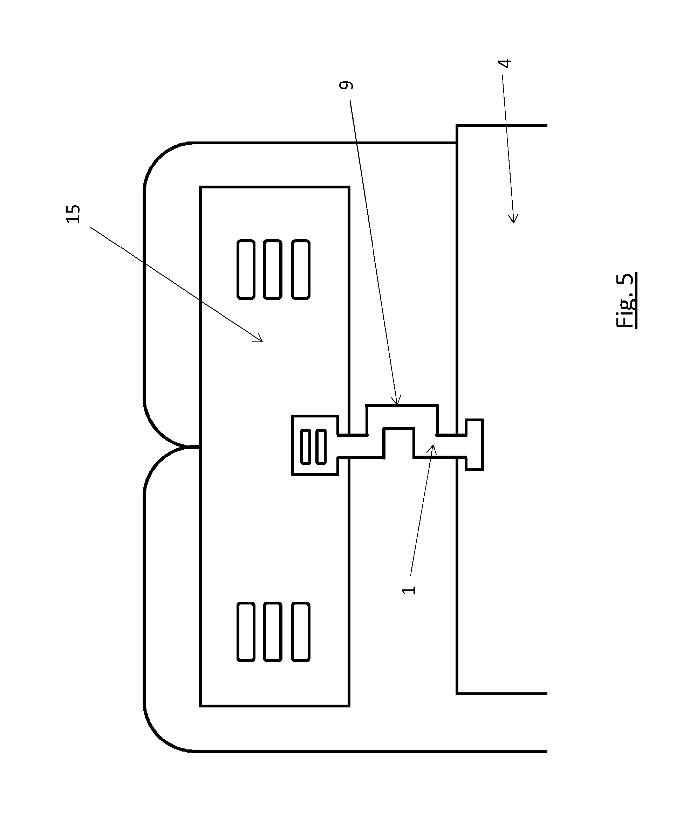

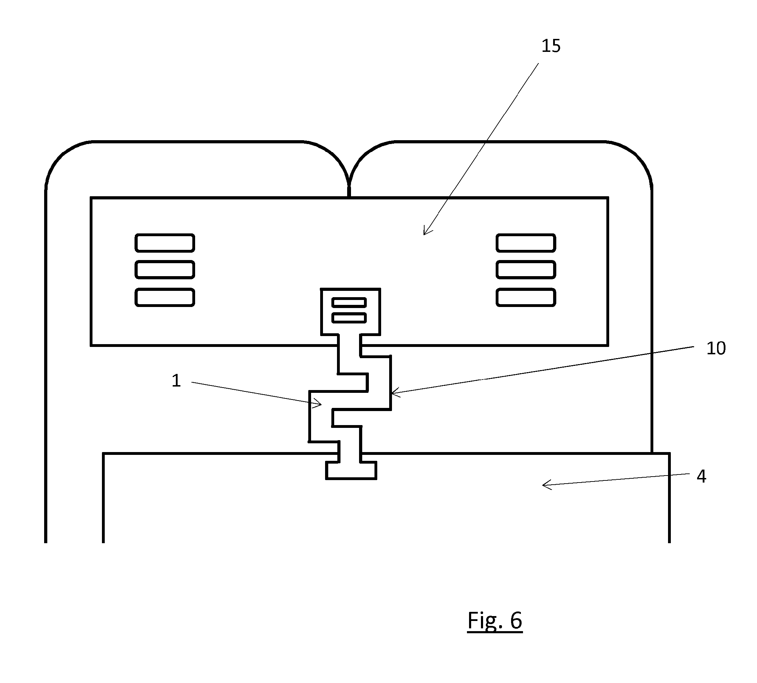

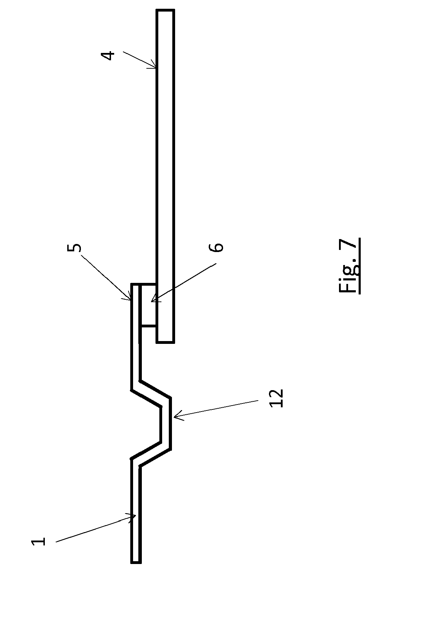

Der Bügel des Spannungsabgriffelementes 1 weist in dessen Mittelteil üblicherweise einen geringeren Querschnitt 8, insbesondere eine geringere Breite auf, als an dessen Enden, die als Kontaktbereiche ausgebildet sind, wie in Fig. 3 ersichtlich. Dieser Mittelteil des Bügels kann einen Haltevorsatz 11 aufweisen, siehe Fig. 4, durch welchen die Handhabung des Bauteiles während der Fertigung erleichtert wird. Weiters kann der Mittelteil des Bügels, wie in den Fig. 5 und Fig. 6 dargestellt, auch Krümmungen aufweisen, beispielsweise die dargestellte annähernde U-Form oder S-Form. Eine vertikale Kröpfung 12, siehe Fig. 7, erleichtert die Ausrichtung des Bügels während der Bestückung der Elektronikeinheit 4 wenn hierfür eine geeignete Aufnahmeplatte zur Positionierung verwendet wird.

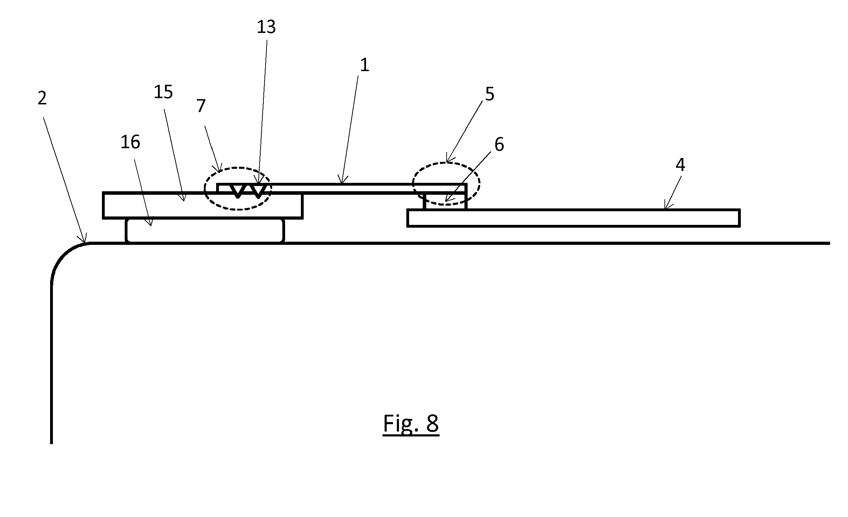

Die Detaildarstellung der Fig. 8 zeigt deutlich die ersten und zweiten Kontaktbereiche 5, 7. Am ersten Kontaktbereich 5 ist ein Zwischenstück 6 auf den Bügel des Spannungsabgriffelementes 1 plattiert. Dieses Zwischenstück 6 ermöglicht die SMD-Bestückung der Bügel auf der Elektronikeinheit 4.

Die gesamte Zellüberwachungseinheit, bestehend aus der Elektronikeinheit 4 und den Spannungsabgriffelementen 1 wird in einem Gehäuse 14 aufgenommen, welches auf die Batteriezellen 2 der Batterieeinheit 3 aufgesetzt wird.

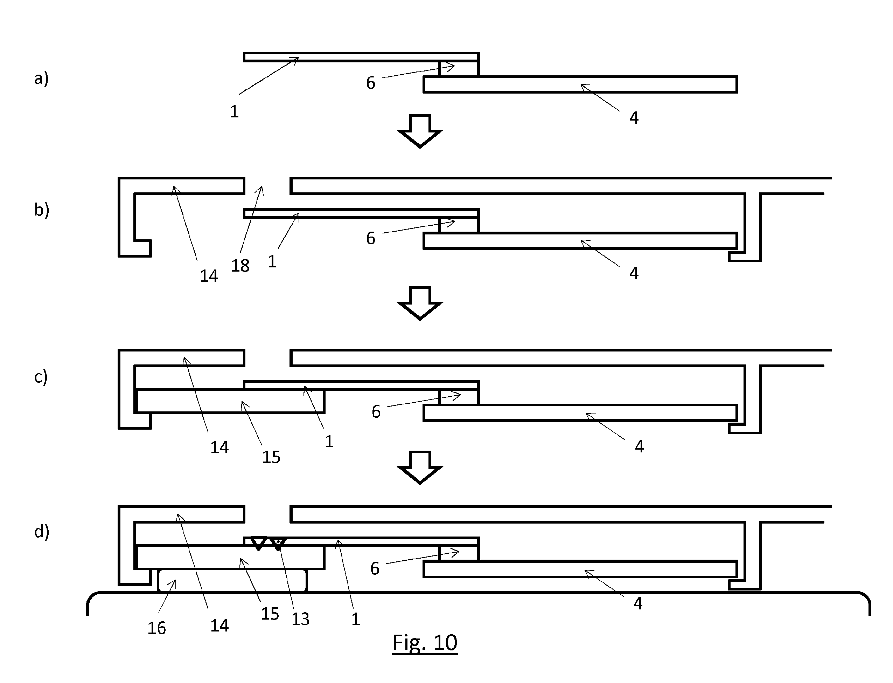

Fig. 10 zeigt schließlich ein erfindungsgemäßes Verfahren zur Herstellung einer Batterieeinheit 3 mit einer Zellüberwachungseinheit. In der Abbildung a) ist die mit Spannungsabgriffelementen 1 vorbestückte Zellüberwachungseinheit dargestellt. Diese Einheit wird, wie in b) dargestellt, in ein Gehäuse 14 eingelegt. In das Gehäuse 14 werden sodann auch die Zellverbinder 15 gedrückt, siehe c). Die entstehende Einheit wird schließlich auf die Batteriezellen 2 mit deren Zellpolen 16 aufgesetzt. Daraufhin werden die Zellverbinder 15 mit den Zellpolen 16 und mit den Spannungsabgriffelementen 1 verschweißt.

### Bezugszeichenliste

- 1: Spannungsabgriffelement
- 2: Batteriezelle
- 3: Batterieeinheit
- 4: Elektronikeinheit
- 5: erster Kontaktbereich
- 6: Zwischenstück
- 7: zweiter Kontaktbereich
- 8: verringerter Querschnitt
- 9: U-förmiger Mittelteil des Bügels
- 10: S-förmiger Mittelteil des Bügels
- 11: Haltevorsatz
- 12: vertikale Kröpfung
- 13: Schweißstelle
- 14: Gehäuse
- 15: Zellverbinder
- 16: Zellpol
- 17: Schweißstelle Zellverbinder-Zellpol
- 18: Öffnung für Verschweißung

## Patentansprüche

1. Spannungsabgriffelement (1) zum Abgriff der Spannung einer Batteriezelle (2) einer Batterieeinheit (3) durch eine Elektronikeinheit (4),
**dadurch gekennzeichnet, dass** das Spannungsabgriffelement (1) als Bügel ausgeführt ist, wobei der Bügel aus einem ersten Metall besteht, wobei das erste Ende des Bügels einen ersten Kontaktbereich (5) zur Verbindung mit der Elektronikeinheit (4) aufweist und im ersten Kontaktbereich (5) der Bügel mit einem Zwischenstück (6) aus einem vom ersten Metall verschiedenen, in SMD-Technologie lötbaren zweiten Metall dauerhaft verbunden ist, wobei das Zwischenstück (6) dazu ausgebildet ist, durch eine Lötverbindung in SMD-Technologie mit der Elektronikeinheit (4) verbunden zu werden, und wobei das zweite Ende des Bügels einen zweiten Kontaktbereich (7) zur Verbindung mit der Batteriezelle (2) aufweist.

2. Spannungsabgriffelement nach Anspruch 1,
**dadurch gekennzeichnet , dass** der Bügel aus Aluminium besteht.

3. Spannungsabgriffelement nach Anspruch 1 oder 2,
**dadurch gekennzeichnet , dass** das Zwischenstück (6) aus Kupfer besteht.

4. Spannungsabgriffelement nach zumindest einem der vorhergehenden Ansprüche,
**dadurch gekennzeichnet, dass** das in SMD-Technologie lötbare Metall des Zwischenstücks (6) verzinnt ist.

5. Spannungsabgriffelement nach zumindest einem der vorhergehenden Ansprüche,
**dadurch gekennzeichnet, dass** das Zwischenstück (6) mit dem Bügel durch Plattierung, insbesondere durch Walzplattierung, verbunden ist.

6. Spannungsabgriffelement nach zumindest einem der vorhergehenden Ansprüche,
**dadurch gekennzeichnet, dass** der Mittelteil des Bügels gegenüber den Kontaktbereichen (5, 7) einen verringerten Querschnitt (8) aufweist.

7. Spannungsabgriffelement nach zumindest einem der vorhergehenden Ansprüche,
**dadurch gekennzeichnet, dass** der Mittelteil des Bügels zumindest eine Krümmung oder einen Versatz oder eine Kröpfung aufweist, insbesondere U-förmig (9) oder S-förmig (10) ausgeführt ist.

8. Spannungsabgriffelement nach zumindest einem der vorhergehenden Ansprüche,
**dadurch gekennzeichnet, dass** der Mittelteil des Bügels einen Haltevorsatz (11) aufweist.

9. Spannungsabgriffelement nach zumindest einem der vorhergehenden Ansprüche,
**dadurch gekennzeichnet, dass** der Mittelteil des Bügels eine vertikale Kröpfung (12) als Positionierhilfe aufweist.

10. Spannungsabgriffelement nach zumindest einem der vorhergehenden Ansprüche,
**dadurch gekennzeichnet, dass** im zweiten Kontaktbereich (7) zumindest eine, bevorzugt zwei oder mehr Schweißstellen (13) vorgesehen sind.

11. Zellüberwachungseinheit, umfassend eine Elektronikeinheit (4) und mehrere Spannungsabgriffelemente (1) nach zumindest einem der Ansprüche 1 bis 10,
**dadurch gekennzeichnet, dass** die Spannungsabgriffelemente (1) über deren Zwischenstücke (6) in SMD-Technologie mit der Elektronikeinheit (4) lötverbunden sind.

12. Zellüberwachungseinheit nach Anspruch 11,
**dadurch gekennzeichnet, dass** die Elektronikeinheit (4) eine Zellüberwachungsschaltung (cell supervisory circuit, CSC) ist.

13. Zellüberwachungseinheit nach Anspruch 11,
**dadurch gekennzeichnet, dass** die Elektronikeinheit (4) eine Verbindungsplatine ist, die an eine Zellüberwachungsschaltung (cell supervisory circuit, CSC) anschließbar ist.

14. Verfahren zur Herstellung einer Zellüberwachungseinheit nach zumindest einem der Ansprüche 11 bis 13,
**gekennzeichnet durch** den Verfahrensschritt,
- löten der Spannungsabgriffelemente (1) an deren Zwischenstücken (6) in SMD-Technologie auf die Elektronikeinheit (4).

15. Batterieeinheit (3) mit einer Zellüberwachungseinheit nach zumindest einem der Ansprüche 11 bis 13.

16. Verfahren zur Herstellung einer Batterieeinheit (3) mit einer Zellüberwachungseinheit nach Anspuch 15,
**gekennzeichnet durch** die Schritte,
- Einlegen der Zellüberwachungseinheit mit vorbestückten Spannungsabgriffelementen (1) in ein Gehäuse (14),
- Einlegen von Zellverbindern (15) in das Gehäuse (14), so dass die Zellverbinder (15) jeweils mit den zweiten Kontaktbereichen (7) der Spannungsabgriffelemente (1) der Zellüberwachungseinheit in Kontakt stehen,
- Auflegen des Gehäuses (14) mit der Zellüberwachungseinheit und den Zellverbindern (15) auf die Batterieeinheit (3), so dass die Zellverbinder (15) mit Zellpolen (16) der Batterieeinheit (3) in Kontakt stehen,
- Verschweißen der Zellverbinder (15) mit den Zellpolen (16) und der zweiten Kontaktbereiche (7) der Spannungsabgriffelemente (1) mit den Zellverbindern (15).
